# FASCICULE DE BREVET EUROPEEN

(11) **EP 3 017 486 B1**
(45) Date de publication et mention de la délivrance du brevet: **07.08.2019**
(21) Numéro de dépôt: 14736774.2
(22) Date de dépôt: 04.07.2014
(51) Int. Cl.: H01L 35/32, F28D 7/16, F28F 1/32

(54) **DISPOSITIF THERMO ELECTRIQUE, NOTAMMENT DESTINE A GENERER UN COURANT ELECTRIQUE DANS UN VEHICULE AUTOMOBILE**
THERMOELEKTRISCHE VORRICHTUNG, INSBESONDERE ZUR ERZEUGUNG VON ELEKTRISCHEM STROM IN EINEM KRAFTFAHRZEUG
THERMOELECTRIC DEVICE, IN PARTICULAR INTENDED FOR GENERATING AN ELECTRIC CURRENT IN AN AUTOMOTIVE VEHICLE

(30) Priorité: 04.07.2013 FR 1301592
(43) Date de publication de la demande: 11.05.2016
(73) Titulaire: Valeo Systemes Thermiques, 78321 Le Mesnil-Saint-Denis (FR)
(72) Inventeur: DE PELSEMAEKER, Georges, F-78125 Poigny-la-Foret (FR); AZZOUZ, Kamel, F-75012 Paris (FR)
(74) Mandataire: Metz, Gaëlle
(86) Numéro de dépôt international: PCT/EP2014/064368
(87) Numéro de publication internationale: WO 2015/001104

(56) Documents cités:
- EP-A1- 2 541 182
- FR-A1- 2 965 402
- US-A1- 2008 028 769
- US-A1- 2012 324 909
- US-A1- 2013 104 953

## Description

La présente invention concerne un dispositif thermo électrique, notamment destiné à générer un courant électrique dans un véhicule automobile.

Dans le domaine automobile, il a déjà été proposé des dispositifs thermo électriques utilisant des éléments, dits thermo électriques, permettant de générer un courant électrique en présence d'un gradient de température entre deux de leurs faces opposées selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Les éléments thermo électriques sont pris en sandwich entre les tubes de façon à être soumis à un gradient de température provenant de la différence de température entre les gaz d'échappement, chauds, et le fluide de refroidissement, froid.

Des tels dispositifs sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans celui-ci pour générer de l'électricité à partir d'une courroie entrainée par le vilebrequin du moteur.

Il a déjà été développé par la titulaire des éléments thermo électriques de forme annulaire, le gradient de température permettant de générer le courant électrique attendu étant imposé entre deux de leurs faces cylindriques opposées. Le fluide chaud et le fluide froid circulent alors coaxialement, l'un circulant à l'intérieur de l'anneau et l'autre à l'extérieur. Cette solution présente cependant des difficultés d'intégration qui entrainent l'engagement d'une quantité de matière importante. Outre des conséquences sur le coût de revient, un tel engagement de matière augmente l'inertie thermique du dispositif et donc son efficacité, en particulier son temps de réponse. Il peut ainsi ne pas être capable de profiter de fortes mais trop courtes augmentation de chaleur.

Le document US 2012/0324909 A1 divulgue un dispositif thermo électrique.

L'invention se propose d'améliorer la situation et concerne à cet effet un dispositif thermo électrique comprenant une pluralité de modules thermo électrique comportant chacun au moins un élément thermo électrique de forme annulaire, susceptible de générer un courant électrique sous l'action d'un gradient de température exercé entre deux de ses faces, l'une, dite première face, étant définie par une surface de périphérie extérieure et l'autre, dite seconde face, étant définie par une surface de périphérie intérieure, ledit dispositif étant configuré pour établir un échange thermique entre ladite première face et un premier fluide et pour établir un échange thermique entre ladite seconde face et un second fluide de sorte que ledit premier fluide et ledit second fluide circulent de manière transversale l'un par rapport à l'autre, au moins deux desdits modules formant un rang de modules dans lequel lesdits modules sont espacés l'un de l'autre selon une première direction parallèle à une direction de circulation du premier fluide dans le dispositif et au moins deux desdits modules formant une rangée de modules dans laquelle lesdits modules sont espacés l'un de l'autre selon une seconde direction, transversale à la première direction.

Grâce à l'orientation transversale de la circulation de fluide, on peut limiter la matière engagée, en particulier côté premier fluide, pour augmenter les surfaces d'échanges. La configuration en rangs et en rangées donne en outre de plus grandes possibilités de positionnement des différentes tubulures destinées à être raccordées au module pour l'alimenter en fluide et facilite ainsi son intégration dans son environnement.

Selon un aspect de l'invention, ledit dispositif thermo électrique est configuré pour permettre une circulation desdits premier et second fluides, ledit second fluide présentant un coefficient d'échange thermique supérieure audit premier fluide. Le premier fluide est, notamment du gaz d'échappement. Le second fluide est, par exemple, un liquide de refroidissement.

L'invention propose ainsi un dispositif dont l'efficacité est optimisée par le fait que la surface d'échange est plus grande au niveau du fluide présentant le coefficient d'échange le plus faible. On dispose de la sorte d'un rapport entre la résistance thermique côté premier fluide, par exemple du gaz, et la résistance thermique côté second fluide, notamment du liquide, plus équilibré, favorisant le fonctionnement de l'ensemble.

Selon un exemple de réalisation de l'invention, la seconde direction est perpendiculaire à la première direction et à une direction de circulation du second fluide dans le dispositif. La circulation du second fluide dans le dispositif s'effectue selon une troisième direction parallèle à un axe défini par la forme annulaire des éléments thermo électrique.

Selon l'invention, le dispositif comprend au moins deux rangs et au moins deux rangées de modules.

De manière avantageuse, deux rangées de modules sont espacées entre elles selon la première direction et deux rangs de modules sont espacés entre eux selon la seconde direction.

Selon un aspect de l'invention, les modules voisins de deux rangées adjacentes sont décalés l'un par rapport à l'autre selon la seconde direction de sorte à être disposés en quinconce. Selon une variante de réalisation de l'invention, les modules voisins de deux rangées adjacentes sont situés au même niveau l'un par rapport à l'autre selon la seconde direction de sorte à être disposés selon un quadrillage.

Selon un exemple de réalisation de l'invention, les modules voisins de deux rangs adjacents sont décalés l'un par rapport à l'autre selon la première direction de sorte à être disposés en quinconce. Selon une variante de réalisation de l'invention, les modules voisins de deux rangs adjacents sont situés au même niveau selon la première direction de sorte à être disposés selon un quadrillage.

Selon l'invention le dispositif comprend une boite collectrice d'entrée du second fluide dans le dispositif et une boite collectrice de sortie du second fluide du dispositif. Le dispositif comprend plusieurs circuits de passage du second fluide à travers les modules entre la boite collectrice d'entrée et la boite collectrice de sortie, les circuits étant indépendant les uns des autres.

Selon un aspect de l'invention, chacun des circuits de passage comprend les modules voisins de chacune des rangées. Il y a donc autant de circuits de passage indépendants que de modules dans chaque rangée.

Avantageusement, chacun des circuits de passage relie successivement les rangées voisines en serpentin.

Selon un exemple de réalisation, les circuits de passage comprennent des tubulures raccordant entre eux les modules voisins de deux rangées différentes, à leurs extrémités.

Selon une forme de réalisation de l'invention, la boite collectrice de sortie du second fluide est située au niveau d'une première rangée de module destinée à entrer en contact en premier avec ledit premier fluide et la boite collectrice d'entrée du second fluide est située au niveau d'une dernière rangée de module destinée à entrer en contact en dernier avec ledit premier fluide.

Selon un aspect de l'invention, la boite collectrice d'entrée et la boite collectrice de sortie sont situées d'un même coté du dispositif.

Avantageusement, ledit dispositif thermo électrique comprend des surfaces d'échange secondaire avec le premier fluide, les surfaces d'échange secondaire étant des ailettes ondulées et/ou perforées et/ou à persiennes. Le fait que les ailettes soient ondulées et/ou perforées et/ou à persiennes permet d'améliorer l'échange thermique entre le premier fluide et le dispositif thermo électrique de l'invention, notamment en augmentant les surfaces d'échanges et en perturbant l'écoulement du premier fluide. Les ailettes sont, notamment, en métal.

Selon un aspect le cylindre formé par lesdits éléments thermo électriques est aminci dans le sens de circulation du premier fluide de sorte qu'il offre moins de résistance au premier fluide. Le cylindre présente notamment une base de forme sensiblement ovale. La forme amincie externe des éléments thermo électriques permet notamment de réduire le maître couple aérodynamique de l'élément thermo électrique et donc de réduire la résistance à l'écoulement des gaz, cela pour un même encombrement total.

Avantageusement, ledit élément thermo électrique présente deux faces planes parallèles opposées.

Selon un exemple chacun des modules comprend une pluralité de dits éléments thermo électriques. Lesdits éléments thermo électriques pourront être disposés les uns par rapport aux autres de façon à ce que leurs première et/ou seconde surfaces soient dans le prolongement l'une de l'autre.

Selon un aspect lesdits éléments thermo électriques sont de deux types différents. De manière avantageuse, lesdits éléments thermo électriques sont ici d'un premier type, dit P, permettant d'établir une différence de potentiel électrique entre lesdites première et seconde faces, lorsqu'ils sont soumis à un gradient de température donné, et d'un second type, dit N, permettant la création d'une différence de potentiel électrique dans un sens opposé entre lesdites première et seconde faces, lorsqu'ils sont soumis au même gradient de température.

Au moins deux éléments thermo électriques du même type pourront alterner selon une direction d'extension longitudinale du module, c'est-à-dire selon la direction de circulation du second fluide, avec un élément thermo électrique de l'autre type. Avantageusement, lesdits éléments thermo électriques sont disposés dans le prolongement longitudinal l'un de l'autre et les éléments thermo électriques de type P alternent avec les éléments thermo électriques de type N.

Selon un aspect les éléments thermo électriques sont groupés par paires, formées d'un dit élément thermo électrique de type P et d'un dit élément thermo électrique de type N, ledit module étant configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine.

Selon un aspect de lesdits éléments thermo électriques sont de forme et de dimension identiques. Autrement dit, ils présentent une périphérie interne, une périphérie externe et une épaisseur, c'est-à-dire, une dimension selon leur axe longitudinal, identiques.

En variante, leur épaisseur pourra être différente, en particulier en fonction de leur conductivité électrique. Plus précisément, les éléments thermo électriques de type N pourront être plus conducteur électriquement que les éléments thermo électriques de type P, et l'épaisseur desdits éléments thermo électrique de type N sera inférieure à l'épaisseur des éléments thermo électriques de type P, ou inversement. Ainsi les résistances électriques des éléments thermo électriques de chacun des types d'éléments thermo électriques pourront être plus équilibrées, avec une épaisseur plus mince d'éléments thermo électriques de type N, ou inversement de type P, et donc une économie de matière.

Selon un aspect le module comprend des premiers moyens de connexion électrique reliant les surfaces de périphérie extérieure de deux desdits éléments thermo électriques, prévus adjacents et de type différent, lesdites surfaces d'échange secondaire étant fixées sur lesdits premiers moyens de connexion électrique. Les surfaces d'échange secondaire sont, par exemple serties aux premiers moyens de connexion électrique. Dans une autre forme de réalisation, elles sont brasées auxdits premiers moyens de connexion électrique, notamment à l'aide d'une brasure conductrice électrique.

Avantageusement, les surfaces d'échange secondaire sont traversées par lesdits éléments thermo électriques.

De manière avantageuse, les surfaces d'échange secondaire s'étendent dans des plans parallèles au sens de circulation du premier fluide.

Selon un aspect les surfaces d'échange secondaire comprennent un revêtement catalytique pour assurer une conversion catalytique de composants toxiques du premier fluide.

Selon un aspect le module comprend des seconds moyens de connexion électrique établissant une connexion électrique entre les surfaces de périphérie intérieur de deux desdits éléments thermo électrique, prévus adjacents, de type différent et non reliés par lesdits premiers moyens de connexion électrique.

De manière avantageuse, lesdits modules comprennent en outre des moyens d'isolation électrique disposés entre deux éléments thermo électriques adjacents, de type différents, lesdits moyens d'isolation électrique étant configurés pour isoler électriquement entre elles des faces latérales des éléments thermo électriques reliés par lesdits premiers et/ou second moyens de connexion électrique et/ou pour isoler électriquement entre elles les surfaces d'échange secondaire liées à deux desdits éléments thermo électrique, reliés par les seconds moyens de connexion électrique. Ainsi, l'invention permet de limiter le risque qu'un court circuit se crée entre les surfaces d'échange secondaire.

Selon un aspect les modules comprennent chacun un canal de circulation du second fluide au contact de ladite seconde surface desdits éléments thermo électriques.

Avantageusement au moins un desdits canaux s'étend selon un axe excentré par rapport à un axe central du cylindre formé par lesdits éléments thermo électrique. En particulier, chacun desdits canaux s'étendent selon un axe excentré par rapport audit axe central du cylindre formé par lesdits éléments thermo électrique.

Selon un aspect l'axe excentré du canal se situe dans un plan défini par l'axe central du cylindre et la direction de circulation du premier fluide. En orientant les éléments thermo électriques par rapport au sens de circulation du premier fluide, on dispose de la sorte d'équipotentielles électriques concentriques à l'intérieur des thermo éléments.

En variante, au moins un des modules et notamment tous les modules pourront comprendre une pluralité de canaux de circulation de liquide froid, notamment parallèles entre eux, chaque canal coopérant avec une pluralité d'éléments thermo électriques formant chacun une section angulaire de cylindre et positionnés les uns dans le prolongement des autres selon la direction d'extension longitudinale du canal correspondant.

Selon un exemple de réalisation lesdites surfaces d'échange secondaires relient les modules entre eux de sorte qu'elles sont traversées par lesdits modules.

Avantageusement, ledit dispositif est configuré pour être positionné dans un conduit de gaz d'échappement de véhicule automobile de sorte que lesdites surfaces d'échange secondaire soient balayées par lesdits gaz, ces derniers définissants ledit premier fluide.

L'invention sera mieux comprise à la lumière de la description suivante qui n'est donnée qu'à titre indicatif et qui n'a pas pour but de la limiter, accompagnée des dessins joints parmi lesquels :
- les figures 1 et 2 illustrent de façon schématique, en perspective, des étapes de montage d'un exemple de module d'un dispositif conforme à l'invention,
- les figures 3 et 4 illustrent de façon schématique, en perspective, des exemples de réalisation d'un dispositif conforme à l'invention,
- la figure 5 illustre en perspective un exemple d'intégration du dispositif de la figure 4 dans une ligne d'échappement,
- la figure 6 illustre de façon schématique, en perspective, un exemple de circuit de circulation du deuxième fluide dans le dispositif illustré à la figure 5,
- la figure 7 illustre de façon schématique, en perspective, un exemple de module d'un dispositif conforme à l'invention,
- la figure 8 illustre de façon schématique, selon un plan de coupe longitudinale, le module de la figure 7,
- la figure 9 illustre de façon schématique, en perspective, une rangée de modules d'un dispositif conforme à l'invention,
- la figure 10 illustre de façon schématique, en perspective, un autre exemple de réalisation d'une rangée de modules,
- La figure 11 illustre de façon schématique, en perspective, une particularité d'un exemple de réalisation d'un module d'un dispositif conforme à l'invention.

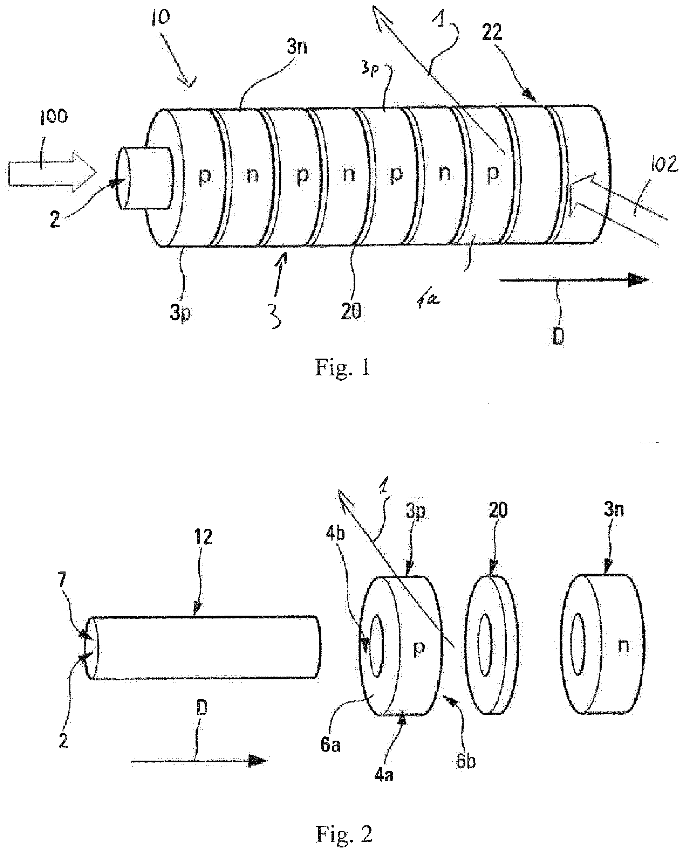

L'invention concerne un dispositif thermo électrique comprenant une pluralité de modules thermo électriques 10 dont un exemple est illustré aux figures 1 et 2. Ledit module 10 comprend ici un premier circuit 1, dit chaud, apte à permettre la circulation d'un premier fluide, notamment des gaz d'échappement d'un moteur, et un second circuit 2, dit froid, apte à permettre la circulation d'un second fluide, notamment un fluide caloporteur d'un circuit de refroidissement, de température inférieure à celle du premier fluide.

Ledit second fluide présente ainsi un coefficient d'échange thermique supérieur audit premier fluide.

Le module 10 comprend au moins un élément thermo électrique, ici une pluralité d'éléments thermo électrique 3, de forme annulaire, susceptibles de générer un courant électrique sous l'action d'un gradient de température exercé entre deux de ses faces, l'une 4a, dite première face, étant définie par une surface de périphérie extérieure, cylindrique, et l'autre 4b, dite seconde face, étant définie par une surface de périphérie intérieure, cylindrique. Comme cela sera développé dans la suite, lesdites première et seconde faces 4a, 4b sont, par exemple, de section ovales pour les premières et/ou circulaires pour les secondes. De façon plus générale, toute section de forme arrondie et/ou polygonale est possible.

De tels éléments fonctionnent, selon l'effet Seebeck, en permettant de créer un courant électrique dans une charge connectée entre lesdites faces 4a, 4b soumises au gradient de température. De façon connue de l'homme du métier, de tels éléments sont constitués, par exemple, de Bismuth et de Tellurium (Bi₂Te₃).

Les éléments thermo électriques pourront être, pour une première partie, des éléments 3p d'un premier type, dit P, permettant d'établir une différence de potentiel électrique dans un sens, dit positif, lorsqu'ils sont soumis à un gradient de température donné, et, pour l'autre partie, des éléments 3n d'un second type, dit N, permettant la création d'une différence de potentiel électrique dans un sens opposé, dit négatif, lorsqu'ils sont soumis au même gradient de température.

Aux figures 1 et 2, les éléments thermo électrique 3 représentés sont constitués d'un anneau en seule pièce. Ils pourront cependant être formés de plusieurs pièces formant chacune une portion angulaire de l'anneau.

La première surface 4a présente, par exemple, un rayon compris entre 1,5 et 4 fois le rayon de la seconde surface 4b. Il pourra s'agir d'un rayon égal à environ 2 fois celui de seconde surface 4b.

Ledit élément thermo électrique présente, par exemple, deux faces planes 6a, 6b parallèles opposées. Autrement dit, l'anneau constituant l'élément thermo électrique est de section annulaire rectangulaire.

On décrit dans la suite un exemple d'association des éléments thermo électriques entre eux dans le module conforme à l'invention.

Lesdits éléments thermo électriques 3 sont disposés, par exemple, dans le prolongement longitudinal l'un de l'autre, notamment de façon coaxiale, et les éléments thermo électriques de type P alternent avec les éléments thermo électriques de type N, selon une direction D, dite troisième direction D. Ils sont, notamment, de forme et de dimension identiques. Ils pourront cependant présenter une épaisseur, c'est-à-dire une dimension entre leurs deux faces planes, différente d'un type à l'autre, notamment en fonction de leur conductivité électrique.

Lesdits éléments thermo électriques 3 sont, par exemple, groupés par paire, chaque paire étant formée d'un dit élément thermo électrique de type P et d'un dit élément thermo électrique de type N, et ledit module est configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine. On assure de la sorte une circulation en série du courant électrique entre les éléments thermo électriques 3 disposés les uns à côtés des autres selon la direction D.

A nouveau pour faciliter la configuration des circuits de circulation de fluide 1, 2, on pourra prévoir que lesdits éléments thermo électriques 3 soient disposés les uns par rapport aux autres de façon à ce que leur première et/ou seconde surface 4a, 4b soient dans le prolongement l'une de l'autre. Lesdites première et/ou seconde surfaces 4a, 4b sont ainsi inscrites, par exemple, dans une surface générée par une droite.

Pour la circulation des fluides, le module conforme à l'invention pourra comprendre un canal 7 de circulation de liquide froid au contact de ladite seconde surface 4b desdits éléments thermo électriques 3.

Le ou lesdits canaux 7 de circulation de liquide sont, par exemple, de section circulaire.

A la figure 2, on constate que ledit module comprend des tubes 12 de circulation de liquide froid sur lequel sont montés au moins deux éléments thermo électriques du même type alternant selon la direction d'extension longitudinale D du tube avec un élément thermo électrique de l'autre type. Les tubes 12 sont, notamment, métalliques. Ils définissent au moins en partie ledit canal 7.

Ledit module 10 pourra comprendre en outre des moyens d'isolation électrique 20 disposés entre deux faces 6a, 6b en vis-à-vis d'éléments thermo électriques voisins 3 selon la troisième direction D correspondant à la direction d'extension longitudinale du tube 12. A la figure 2, les éléments thermo électriques 3, et les moyens d'isolation électrique 20 sont assemblés, de façon alternée, sur les tubes 12 de circulation de fluide froid.

Ledit module pourra en outre comprendre des premiers moyens 22 de connexion électrique reliant les surfaces de périphérie extérieure 4a de deux desdits éléments thermo électriques, prévus adjacents et de types différents. Lesdits premiers moyens 22 de connexion électrique comprennent, par exemple, une couche de matière électriquement conductrice, notamment en cuivre et/ou en nickel, de revêtement desdits éléments thermo électriques 3.

Selon ce qui précède, le canal 7 de circulation de liquide froid est unique et placé au centre du module. Selon une variante, il pourra être prévu une pluralité de canaux de circulation de liquide froid dans le prolongement les uns des autres.

Cela étant, comme illustré à la figure 1, ledit module est configuré pour établir un échange thermique entre ladite première face 4a et le premier fluide, circulant ici à l'extérieur desdits éléments thermo électrique 3 selon la flèche illustrée 102, et pour établir un échange thermique entre ladite seconde face 4b et le second fluide, circulant ici dans le canal 7 selon la flèche illustré 100. On favorise ainsi l'échange entre les éléments thermo électriques 3, et le fluide présentant le coefficient d'échange thermique le plus faible, ici, les gaz d'échappement.

Ledit module est en outre configuré pour que ledit premier fluide et ledit second fluide circulent de manière transversale, notamment orthogonale, l'un par rapport à l'autre, tel que cela est illustré par l'orientation des flèches 100, 102. Une telle configuration favorise l'intégration du module dans son environnement en diminuant par ailleurs les quantités de matière engagées.

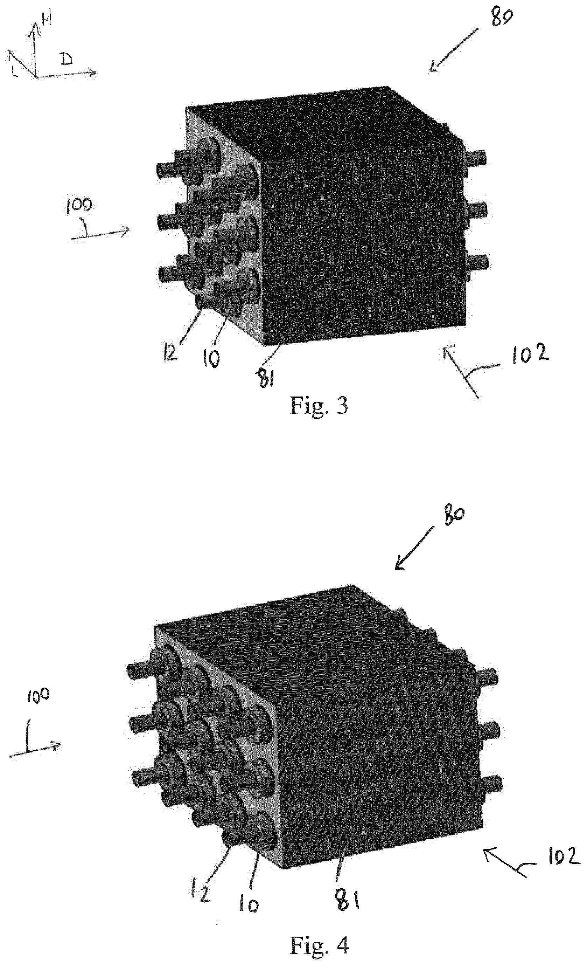

Un dispositif thermo électrique 80 comprenant une pluralité desdits modules 10 selon l'invention est illustré aux figures 3 et 4. Un tel dispositif thermo électrique comprend au moins deux desdits modules 10 formant un rang de modules et au moins deux desdits modules formant une rangée de modules. Les modules 10 appartenant à un même rang de modules sont espacés les uns des autres selon une première direction L et situés au même niveau selon une seconde direction H transversale à la première. Les modules 10 appartenant à une même rangée de modules sont espacés les uns des autres selon la seconde direction H et situés au même niveau selon la première direction L.

La première direction L est notamment parallèle à la direction de circulation du premier fluide 102 dans le dispositif et la seconde direction H est perpendiculaire à la première direction L et à la direction de circulation du second fluide 100 dans le dispositif.

Les modules 10 s'étendent ainsi longitudinalement dans le dispositif 80 selon la troisième direction D, sont disposées en rang selon la première direction L et en rangée selon la deuxième direction H.

La première direction L, la deuxième direction H et/ou la troisième direction D sont par exemple perpendiculaires entre elles comme illustré sur les figures 3 et 4.

Dans les exemples illustrés aux figures 3 et 4, le dispositif de l'invention comprend plusieurs rangées de modules 10 et plusieurs rangs de module 10. Ici, deux rangées de modules 10 sont espacées entre elles selon la première direction L et deux rangs de modules sont espacés entre eux selon la seconde direction H.

Dans l'exemple illustré à la figure 3, les modules 10 voisins de deux rangées adjacentes sont décalés l'un par rapport à l'autre selon la seconde direction H en plus d'être décalé selon la première direction L de sorte à être disposés en quinconce. On appelle modules 10 voisins de deux rangées adjacentes, les modules 10 qui ont la même position dans leurs rangées respectives, c'est-à-dire les premiers modules des rangées en partant du bas selon la deuxième direction H, les modules situés juste au dessus des premiers modules etc. Dans cette variante de réalisation de l'invention, les rangées de modules comportent le même nombre de modules et les rangs de modules comportent un module de moins.

Selon l'exemple de réalisation de l'invention illustré à la figure 3, le dispositif de l'invention comprend trois rangées de trois modules 10 et six rangs de deux modules 10. Il pourrait bien sûr comprendre un nombre différent de rangées et/ou de rangs ainsi que de modules 10 par rangée et/ou de modules 10 par rang.

Dans l'exemple de réalisation illustré à la figure 4, les modules 10 voisins de deux rangées adjacentes sont situés au même niveau l'un par rapport à l'autre selon la seconde direction H de sorte à être disposés selon un quadrillage. Les modules 10 voisins de deux rangs adjacents sont situés au même niveau selon la première direction L de sorte à être disposés selon un quadrillage. Ainsi, le nombre de modules 10 que comprend une rangée est égale au nombre de rangs et le nombre de modules 10 que comprend un rang est égale au nombre de rangées. Dans cet exemple, le dispositif 80 de l'invention comprend quatre rangées de trois modules 10 chacune et trois rangs de quatre module 10 chacun mais il pourrait bien sûr comprendre un nombre différents de rangées et/ou de rangs ainsi que de modules 10 par rangées et/ou de modules 10 par rang.

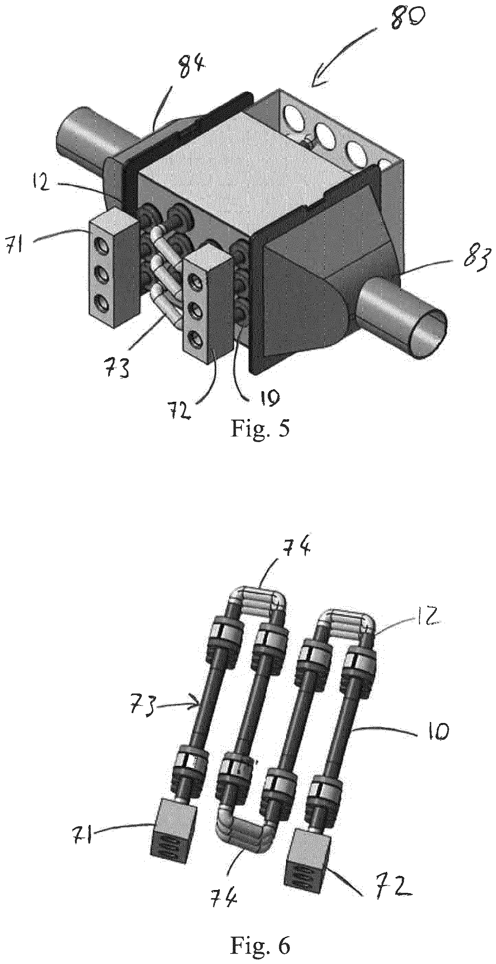

Comme illustré à la figure 5, le dispositif de l'invention comprend une boite collectrice d'entrée 71 du second fluide dans le dispositif 80 et une boite collectrice de sortie 72 du second fluide du dispositif, le dispositif comprenant plusieurs circuits 73 de passage du second fluide à travers les modules 10 entre la boite collectrice d'entrée 71 et la boite collectrice de sortie 72, les circuits 73 étant indépendant les uns des autres. La boite collectrice de sortie 72 du second fluide est ici située au niveau d'une première rangée de module 10 destinée à entrer en contact en premier avec ledit premier fluide, c'est-à-dire la rangée de modules 10 située le plus près de la face d'entrée 81, et la boite collectrice d'entrée 71 du second fluide est située au niveau d'une dernière rangée de modules 10 destinée à entrer en contact en dernier avec ledit premier fluide. On réalise de la sorte une circulation à contre-courant. La boite collectrice d'entrée 71 et la boite collectrice de sortie 72 sont situées d'un même coté du dispositif, ici un coté latéral du dispositif par rapport à la face d'entrée du premier fluide dans le dispositif.

Le dispositif de l'invention comprend également une boite collectrice d'entrée 83 du premier fluide dans le dispositif en vis-à-vis de la face d'entrée du premier fluide dans le dispositif 80, et une boite collectrice de sortie 84 du deuxième fluide, située à l'opposé de la boite collectrice d'entrée 83 du premier fluide dans le dispositif par rapport au dispositif.

Selon l'invention, chacun des circuits de passage 73 comprend les modules 10 voisins de chacune des rangées. Ainsi il y a autant de circuits indépendants que de modules 10 par rangée. Chacun des circuits 73 relie ici successivement les rangées voisines en serpentin. Le second fluide arrive dans la boite collectrice d'entrée 71, entre dans un des modules 10 de la rangée située au niveau de la boite collectrice d'entrée 71, le traverse dans le sens de la longueur selon la troisième direction D comme vu précédemment, passe dans un module 10 voisin d'une rangée adjacente et le traverse selon la même direction mais en sens opposé. Le second fluide continue son trajet jusqu'à atteindre la boite collectrice de sortie 72. Dans l'exemple illustré à la figure 5, le dispositif 80 présente quatre rangées et le second fluide effectue donc quatre passage avant d'arriver dans la boite collectrice de sortie en circulant dans le dispositif 80 en serpentin.

Comme visible de manière plus détaillée à la figure 6, les circuits 73 de passage comprennent des tubulures 74 raccordant entre eux les modules 10 voisins de deux rangées différentes, à leurs extrémités. Ces tubulures ont notamment la forme d'un U.

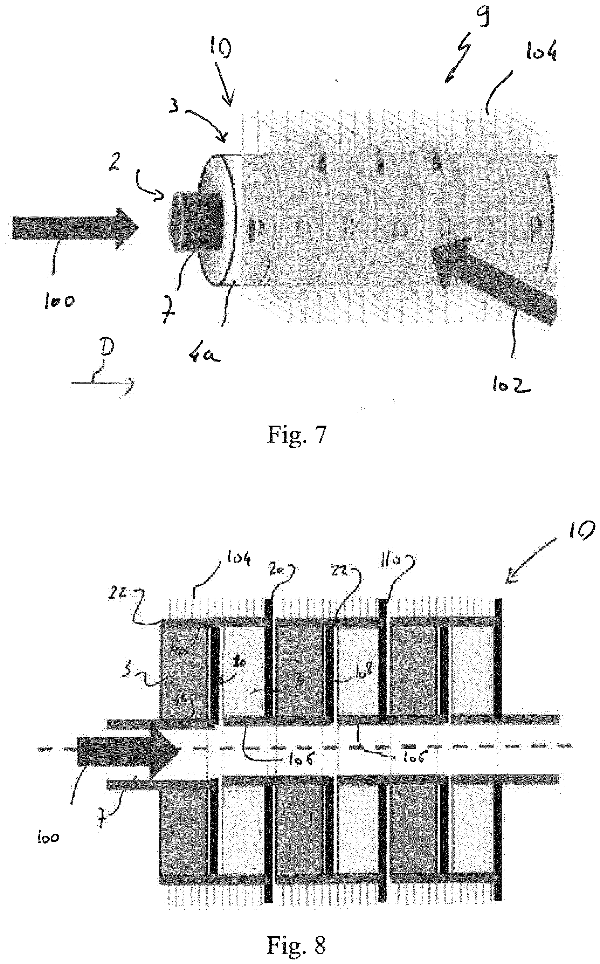

Comme illustré à la figure 7, ledit module comprend avantageusement des surfaces d'échange secondaire 9, en particulier des ailettes 104, avec le premier fluide. On augmente de la sorte la surface d'échange entre les éléments thermo électriques 3 et ledit premier fluide. Lesdites ailettes 104 sont disposées, par exemple, transversalement, en particulier radialement auxdits éléments thermo électriques 3. Elles sont ici positionnées parallèlement les unes aux autres avec un écartement permettant un bon échange de chaleur avec le premier fluide tout en limitant les pertes de charges. Lesdites ailettes 104 pourront être décentrées par rapport auxdits éléments thermo électriques 3, notamment allongées du côté de l'arrivée du premier fluide.

Lesdites ailettes 104 sont par exemple ondulées, perforées et/ou à persiennes.

Lesdites surfaces d'échange secondaire 9 pourront comprendre un revêtement catalytique pour assurer une conversion catalytique de composants toxiques du premier fluide. Dans le cas de gaz d'échappement, ledit module pourra de la sorte équiper un pot catalytique en complément ou substitution des composants servant classiquement à la catalyse dans de tels équipements.

Comme illustré à la figure 8, lesdites ailettes 104 sont fixées, par exemple, sur lesdits premiers moyens 22 de connexion électrique, notamment par sertissage et/ou brasage.

Le module pourra en outre comprendre des seconds moyens 106 de connexion électrique établissant une connexion électrique entre les surfaces de périphérie intérieur 4b de deux desdits éléments thermo électrique 3, prévus adjacents, de types différents et non reliés par lesdits premiers moyens 22 de connexion électrique.

Autrement dit, lesdits premiers et seconds moyens de connexion électrique 22, 106 relient deux à deux lesdits éléments thermo électriques 3 de façon à établir une circulation électrique en série entre lesdits éléments thermo électrique du module.

Comme déjà évoqué, les modules 10 comprennent avantageusement, des moyens 20 d'isolation électrique disposés entre deux éléments thermo électriques 3 adjacents. Lesdits moyens d'isolation électrique sont de deux types. Un premier type 108 est configuré pour isoler électriquement entre elles les faces latérales des éléments thermo électriques reliés par lesdits premiers moyens 22 de connexion électrique. Un second type 110 est configuré pour isoler électriquement entre elles les faces latérales des éléments thermo électriques reliés par lesdits second moyens 106 de connexion électrique et/ou pour isoler électriquement entre elles les ailettes 104 liées à deux desdits éléments thermo électrique, reliés par les seconds moyens 106 de connexion électrique.

Une telle configuration permet de limiter les risques de court-circuit entre les éléments thermo électriques 3 qui pourraient intervenir par l'intermédiaire desdites ailettes 106.

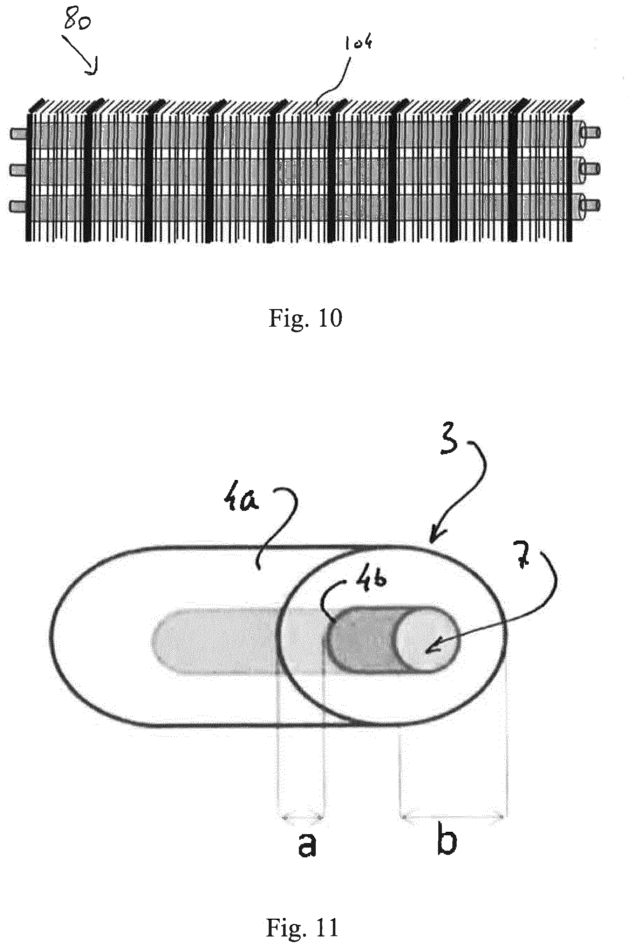

Comme illustré à la figure 11, ledit canal 7 pourra s'étendre selon un axe excentré par rapport à un axe central d'un cylindre formé par lesdits éléments thermo électrique 3, représenté ici en un seul bloc, dans un souci de simplification. Ledit axe excentré du canal se situe, par exemple, dans un plan défini par l'axe central du cylindre et la direction de circulation du premier fluide. En faisant varier de la sorte l'épaisseur des éléments thermo électriques 3 autour du canal 7, on obtient une meilleure répartition des équipotentielles de courant dans les éléments thermo électriques 3.

Alternativement ou cumulativement, ledit cylindre est aminci dans le sens de circulation du premier fluide de sorte qu'il offre moins de résistance au premier fluide. Cela étant, en variante, lesdites première et/ou seconde surfaces 4a, 4b pourront être coaxiales. Autrement dit, l'élément thermo électrique est muni d'une épaisseur radiale constante.

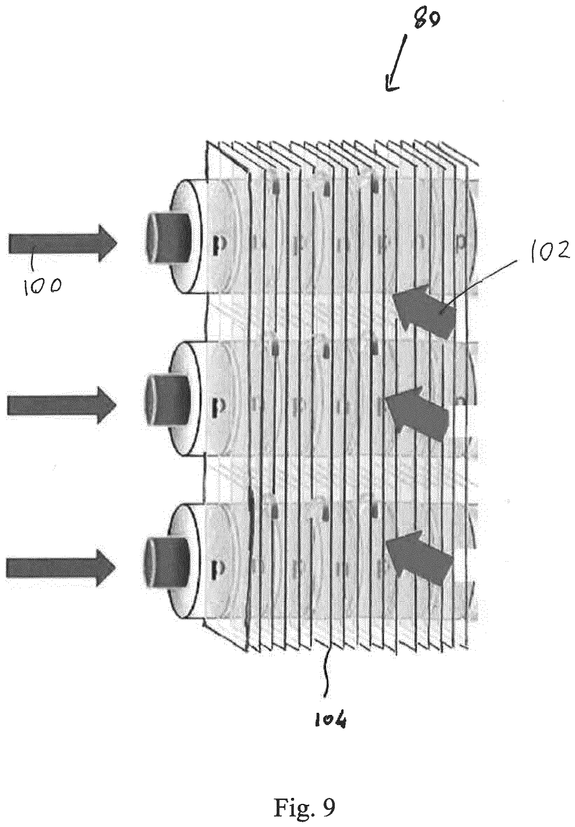

Comme illustré aux figures 9 et 10, lesdites ailettes 104 relient les modules entre eux de sorte qu'elles sont traversées par lesdits modules. Sur ces figures, une seules desdites rangées est illustrée.

D'un point de vue électrique, les modules pourront être connectés entre eux en série et/ou en parallèle, par des connexions, non représentées, situées à leurs extrémités longitudinales.

Comme déjà évoqué, un tel dispositif pourra être configuré pour être positionnée dans un conduit de gaz d'échappement de véhicule automobile de sorte que lesdites surfaces d'échange secondaire soient balayées par lesdits gaz. Autrement dit, les gaz sont destinés à être canalisés à travers les ailettes par le conduit de gaz d'échappement lui-même tandis que la circulation du second fluide pourra se faire par les boites collectrices d'entrée/sortie positionnée latéralement, d'où une grande simplicité d'intégration.

De manière générale, on comprend que l'invention, en faisant circuler le fluide chaud à l'extérieur des éléments thermo électriques et transversalement à la circulation du fluide froid, permet d'optimiser les surfaces d'échange de chaleur en contact avec lesdits éléments thermo électrique, favorisant l'obtention de températures élevées au niveau de la surface extérieure desdits éléments thermo électrique. Elle favorise également l'implantation des dispositifs équipés.

## Revendications

1. Dispositif thermo électrique (80) comprenant une pluralité de modules thermo électrique (10) comportant chacun au moins un élément thermo électrique (3, 3p, 3n) de forme annulaire, susceptible de générer un courant électrique sous l'action d'un gradient de température exercé entre deux de ses faces, l'une (4a), dite première face, étant définis par une surface de périphérie extérieure et l'autre (4b), dite seconde face, étant définie par une surface de périphérie intérieure, ledit dispositif étant configuré pour établir un échange thermique entre ladite première face (4a) et un premier fluide et pour établir un échange thermique entre ladite seconde face (4b) et un second fluide de sorte que ledit premier fluide et ledit second fluide circulent de manière transversale l'un par rapport à l'autre,
au moins deux desdits modules (10) formant un rang de modules (10) dans lequel lesdits modules (10) sont espacés l'un de l'autre selon une première direction (L) parallèle à une direction de circulation (102) du premier fluide dans le dispositif (80) et au moins deux desdits modules (10) formant une rangée de modules (10) dans laquelle lesdits modules (10) sont espacés l'un de l'autre selon une seconde direction (H), transversale à la première direction (L), dans lequel le dispositif (80) comprend :
- au moins deux rangs et au moins deux rangées de modules (10),
- une boite collectrice d'entrée (71) du second fluide dans le dispositif (80) et une boite collectrice de sortie (72) du second fluide du dispositif (80), le dispositif (80) comprenant plusieurs circuits de passage (73) du second fluide à travers les modules (10) entre la boite collectrice d'entrée (71) et la boite collectrice de sortie (72), les circuits (73) étant indépendant les uns des autres.

2. Dispositif thermo électrique (80) selon la revendication 1, dans lequel la seconde direction (H) est perpendiculaire à la première direction (L) et à une direction de circulation (100) du second fluide dans le dispositif (60).

3. Dispositif thermo électrique salon la revendication 1, dans lequel deux rangées de modules (10) sont espacées entre elles selon la première direction (L) et deux rangs de modulas (10) sont espacés entre eux selon la seconde direction (H).

4. Dispositif thermo électrique (80) selon la revendication 3, dans lequel les modules (10) voisins de deux rangées adjacentes sont décalés l'un par rapport à l'autre selon la seconde direction (H) de sorte à être disposés en quinconce.

5. Dispositif thermo électrique (80) selon la revendication 3, dans lequel les modules (10) voisins de deux rangées adjacentes sont situés au même niveau l'un par rapport à l'autre selon la seconde direction (H) de sorte à être disposés selon un quadrillage.

6. Dispositif thermo électrique (60) selon la revendication 3, dans lequel les modules (10) voisins de deux rangs adjacents sont décalés l'un par rapport à l'autre selon la première direction (L) de sorte à être disposés en quinconce.

7. Dispositif thermo électrique (80) selon la revendication 3, dans lequel les modules (10) voisins de deux rangs adjacents sont situés au même niveau selon la première direction (L) de sorte à être disposés selon un quadrillage.

8. Dispositif thermo électrique (80) selon la revendication 1, dans lequel chacun des circuits de passage (73) comprend les modules (10) voisins de chacune des rangées.

9. Dispositif thermo électrique (80) selon la revendication 8, dans lequel chacun des circuits de passage (73) relie successivement les rangées voisines en serpentin.

10. Dispositif thermo électrique (80) selon l'une quelconque des revendications 8 ou 9, dans lequel les circuits de passage (73) comprennent des tubulures (74) raccordant entre eux les modules (10) voisins de deux rangées différentes, à leurs extrémités.

11. Dispositif thermo électrique (80) selon l'une des revendications 1 à 9, dans lequel la boite collectrice de sortie (72) du second fluide est située au niveau d'une première rangée de module (10) destinée à entrer en contact en premier avec ledit premier fluide et la boite collectrice d'entrée (71) du second fluide est située au niveau d'une dernière rangée de module (10) destinée à entrer en contact en dernier avec ledit premier fluide,

12. Dispositif thermo électrique (80) selon la revendication 11, dans lequel la boite collectrice d'entrée (71) et la boite collectrice de sortie (72) sont situées d'un même coté du dispositif (80).

13. Dispositif selon l'une quelconque des revendications précédentes, comprenant des surfaces d'échange secondaire (9) avec le premier fluide, les surfaces d'échange secondaire (9) étant des ailettes (104) ondulées et/ou perforées et/ou à persiennes.

## Patentansprüche

1. Thermoelektrische Vorrichtung (80), welche eine Vielzahl von thermoelektrischen Modulen (10) aufweist, welche jeweils mindestens ein ringförmiges, thermoelektrisches Element (3, 3p, 3n) umfassen, welches geeignet ist, einen elektrischen Strom unter der Einwirkung eines zwischen zwei seiner Flächen ausgebildeten Temperaturgradienten zu erzeugen, wobei die eine (4a), so genannte erste Fläche, durch eine äußere Umfangsfläche definiert ist, und die andere (4b), so genannte zweite Fläche, durch eine innere Umfangsfläche definiert ist, wobei die Vorrichtung dafür ausgelegt ist, um einen Wärmeaustausch zwischen der ersten Fläche (4a) und einem ersten Fluid herzustellen und um einen Wärmeaustausch zwischen der zweiten Fläche (4b) und einem zweiten Fluid herzustellen, so dass das erste Fluid und das zweite Fluid quer in Bezug zueinander strömen,
wobei mindestens zwei der Module (10) eine Reihe von Modulen (10) bilden, in welcher die Module (10) in einer ersten Richtung (L), welche parallel zu einer Strömungsrichtung (102) des ersten Fluids in der Vorrichtung (80) verläuft, voneinander beabstandet sind, und wobei mindestens zwei der Module (10) eine Aneinanderreihung von Modulen (10) bilden, in welcher die Module (10) gemäß einer zweiten Richtung (H), welche quer zu der ersten Richtung (L) verläuft, voneinander beabstandet sind, bei welcher die Vorrichtung (80) aufweist:
- mindestens zwei Reihen und mindestens zwei Aneinanderreihungen von Modulen (10),
- einen Eintritt-Sammelbehälter (71) des zweiten Fluids in der Vorrichtung (80) und einen Austritt-Sammelbehälter (72) des zweiten Fluids der Vorrichtung (80), wobei die Vorrichtung (80) mehrere Durchgangswege (73) des zweiten Fluids durch die Module (10) hindurch zwischen dem Eintritt-Sammelbehälter (71) und dem Austritt-Sammelbehälter (72) aufweist, wobei die Wege (73) voneinander unabhängig sind.

2. Thermoelektrische Vorrichtung (80) nach Anspruch 1, bei welcher die zweite Richtung (H) senkrecht zu der ersten Richtung (L) und zu einer Strömungsrichtung (100) des zweiten Fluids in der Vorrichtung (80) verläuft.

3. Thermoelektrische Vorrichtung nach Anspruch 1, bei welcher zwei Aneinanderreihungen von Modulen (10) gemäß der ersten Richtung (L) untereinander beabstandet sind und zwei Reihen von Modulen (10) gemäß der zweiten Richtung (H) untereinander beabstandet sind.

4. Thermoelektrische Vorrichtung (80) nach Anspruch 3, bei welcher die Module (10), welche zu zwei angrenzenden Aneinanderreihungen benachbart sind, in der zweiten Richtung (H) in Bezug zueinander verschoben sind, um versetzt angeordnet zu sein.

5. Thermoelektrische Vorrichtung (80) nach Anspruch 3, bei welcher die Module (10), welche zu zwei angrenzenden Aneinanderreihungen benachbart sind, sich in der zweiten Richtung (H) auf gleicher Höhe in Bezug zueinander befinden, um gemäß einem Raster angeordnet zu sein.

6. Thermoelektrische Vorrichtung (80) nach Anspruch 3, bei welcher die Module (10), welche zu zwei angrenzenden Reihen benachbart sind, in der ersten Richtung (L) in Bezug zueinander verschoben sind, um versetzt angeordnet zu sein.

7. Thermoelektrische Vorrichtung (80) nach Anspruch 3, bei welcher die Module (10), welche zu zwei angrenzenden Reihen benachbart sind, sich in der ersten Richtung (L) auf gleicher Höhe befinden, um gemäß einem Raster angeordnet zu sein.

8. Thermoelektrische Vorrichtung (80) nach Anspruch 1, bei welcher jeder der Durchgangswege (73) die Module (10) aufweist, welche zu jeder der Aneinanderreihungen benachbart sind.

9. Thermoelektrische Vorrichtung (80) nach Anspruch 8, bei welcher jeder der Durchgangswege (73) die benachbarten Reihen in Schlangenlinie aufeinander folgend verbindet.

10. Thermoelektrische Vorrichtung (80) nach einem der Ansprüche 8 oder 9, bei welcher die Durchgangswege (73) Rohre (74) aufweisen, welche die Module (10), welche zu zwei verschiedenen Aneinanderreihungen benachbart sind, untereinander an ihre Enden verbinden.

11. Thermoelektrische Vorrichtung (80) nach einem der Ansprüche 1 bis 9, bei welcher sich der Austritt-Sammelbehälter (72) des zweiten Fluids auf Höhe einer ersten Aneinanderreihung von Modulen (10) befindet, welche dafür vorgesehen ist, als erste mit dem ersten Fluid in Kontakt zu kommen, und sich der Eintritt-Sammelbehälter (71) des zweiten Fluids auf Höhe einer letzten Aneinanderreihung von Modulen (10) befindet, welche dafür vorgesehen ist, als letzte mit dem ersten Fluid in Kontakt zu kommen.

12. Thermoelektrische Vorrichtung (80) nach Anspruch 11, bei welcher sich der Eintritt-Sammelbehälter (71) und der Austritt-Sammelbehälter (72) auf einer gleichen Seite der Vorrichtung (80) befinden.

13. Vorrichtung nach einem der vorhergehenden Ansprüchen, aufweisend sekundäre Flächen (9) zum Austausch mit dem ersten Fluid, wobei die sekundären Austauschflächen (9) gewellte und/oder perforierte und/oder gerasterte Rippen (104) sind.

## Claims

1. Thermoelectric device (80) comprising a plurality of thermoelectric modules (10) each comprising at least one thermoelectric element (3, 3p, 3n) of annular form, capable of generating an electric current under the action of a temperature gradient exerted between two of its faces, one (4a), called first face, being defined by an outer periphery surface and the other (4b), called second face, being defined by an inner periphery surface, said device being configured to establish a heat exchange between said first face (4a) and a first fluid and to establish a heat exchange between said second face (4b) and a second fluid so that said first fluid and said second fluid circulate transversely relative to one another,
at least two of said modules (10) forming a rank of modules (10) in which said modules (10) are spaced apart from one another in a first direction (L) parallel to a direction of circulation (102) of the first fluid in the device (80) and at least two of said modules (10) forming a row of modules (10) in which said modules (10) are spaced apart from one another in a second direction (H), transversal to the first direction (L), wherein the device (80) comprises:
- at least two ranks and at least two rows of modules (10),
- an inlet manifold box (71) for the second fluid to enter into the device (80) and an outlet manifold box (72) for the second fluid to exit from the device (80), the device (80) comprising several circuits of passage (73) for the second fluid to pass through the modules (10) between the inlet manifold box (71) and the outlet manifold box (72), the circuits (73) being independent of one another.

2. Thermoelectric device (80) according to Claim 1, wherein the second direction (H) is at right angles to the first direction (L) and to a direction of circulation (100) of the second fluid in the device (80).

3. Thermoelectric device according to Claim 1, wherein two rows of modules (10) are spaced apart from one another in the first direction (L) and two ranks of modules (10) are spaced apart from one another in the second direction (H).

4. Thermoelectric device (80) according to Claim 3, wherein the neighbouring modules (10) of two adjacent rows are offset relative to one another in the second direction (H) so as to be arranged in staggered configuration.

5. Thermoelectric device (80) according to Claim 3, wherein the neighbouring modules (10) of two adjacent rows are situated at the same level relative to one another in the second direction (H) so as to be arranged in a grid configuration.

6. Thermoelectric device (80) according to Claim 3, wherein the neighbouring modules (10) of two adjacent ranks are offset relative to one another in the first direction (L) so as to be arranged in staggered configuration.

7. Thermoelectric device (80) according to Claim 3, wherein the neighbouring modules (10) of two adjacent ranks are situated at the same level in the first direction (L) so as to be arranged in a grid configuration.

8. Thermoelectric device (80) according to Claim 1, wherein each of the circuits of passage (73) comprises the neighbouring modules (10) of each of the rows.

9. Thermoelectric device (80) according to Claim 8, wherein each of the circuits of passage (73) successively links the neighbouring rows in a winding configuration.

10. Thermoelectric device (80) according to either one of Claims 8 and 9, wherein the circuits of passage (73) comprise nozzles (74) coupling together the neighbouring modules (10) of two different rows, at their ends.

11. Thermoelectric device (80) according to one of Claims 1 to 9, wherein the outlet manifold box (72) for the second fluid is situated at the level of a first row of modules (10) intended to enter into contact first with said first fluid and the inlet manifold box (71) for the second fluid is situated at the level of a last row of modules (10) intended to enter into contact last with said first fluid.

12. Thermoelectric device (80) according to Claim 11, wherein the inlet manifold box (71) and the outlet manifold box (72) are situated on the same side of the device (80).

13. Device according to any one of the preceding claims, comprising secondary exchange surfaces (9) with the first fluid, the secondary exchange surfaces (9) being corrugated and/or perforated and/or louvered fins (104).
